# EUROPÄISCHE PATENTSCHRIFT

(11) **EP 4 666 081 B1**
(45) Veröffentlichungstag und Bekanntmachung des Hinweises auf die Patenterteilung: **09.12.2026**
(21) Anmeldenummer: 24728938.2
(22) Anmeldetag: 21.05.2024
(51) Int. Cl.: G01R 31/12, H02H 1/00, H02H 3/44

(54) **VERFAHREN ZUM ERKENNEN EINES SERIELLEN LICHTBOGENS IN EINEM STROMKREIS**
METHOD FOR IDENTIFYING A SERIAL ARC IN AN ELECTRIC CIRCUIT
PROCÉDÉ D'IDENTIFICATION D'UN ARC SÉRIE DANS UN CIRCUIT ÉLECTRIQUE

(30) Priorität: 30.05.2023 DE 102023205036
(43) Veröffentlichungstag der Anmeldung: 24.12.2025
(73) Patentinhaber: Ellenberger & Poensgen GmbH, 90518 Altdorf (DE)
(72) Erfinder: KÖPF, Hendrik-Christian, 90480 Nürnberg (DE); STEEGMÜLLER, Peter, 90449 Nürnberg (DE); STROBL, Christian, 90419 Nürnberg (DE)
(74) Vertreter: FDST Patentanwälte
(86) Internationale Anmeldenummer: PCT/EP2024/063968
(87) Internationale Veröffentlichungsnummer: WO 2024/245827

(56) Entgegenhaltungen:
- CN-A- 107 024 644
- CN-A- 109 478 775
- US-A1- 2012 050 933

## Beschreibung

Die Erfindung betrifft ein Verfahren zum Erkennen eines seriellen Lichtbogens in einem Stromkreis. Ferner betrifft die Erfindung einen Schutzschalter, eine Anlage mit einem Schutzschalter sowie die Verwendung eines Schutzschalters.

Stromkreise weisen üblicherweise zumindest eine Last und eine Spannungsquelle auf, die mittels einer Leitung elektrisch verbunden sind. Als Leitung wird zumindest abschnittsweise meist ein Kabel oder eine Stromschiene herangezogen. Hierbei ist es möglich, dass aufgrund von mechanischen Belastungen ein Kabelbruch auftritt oder sich Klemm-, Schraub oder Steckverbinder lösen, sodass zwei zueinander beabstandete Kontaktstellen gebildet werden. Falls zwischen diesen eine vergleichsweise hohe elektrische Spannung anliegt, ist es dann möglich, dass die in der Umgebung der beiden Stellen umgebende Luft ionisiert wird und sich hierüber ein Lichtbogen zwischen den beiden Stellen ausbildet, der auch als serieller Lichtbogen (Arc) bezeichnet wird. Aufgrund des Lichtbogens erfolgt eine Erwärmung, und daher ist eine Entzündung oder Beschädigung von sich in der Umgebung befindenden Objekten möglich. Daher ist ein Unterbrechen eines Stromflusses über die Leitung erforderlich, was zu einem Erlöschen des Lichtbogens führt.

Falls als Stromkreis ein Gleichstromkreis herangezogen wird, ergeben sich bei einem seriellen Lichtbogen hochfrequente Anteile in dem mittels der Leitung geführten elektrischen Stroms. Somit ist es zum Erkennen eines derartigen Lichtbogens prinzipiell möglich, eine Frequenzanalyse des mittels der Leitung geführten elektrischen Stroms durchzuführen. Falls darin in einem breiten Frequenzband hochfrequente Anteile vorhanden sind, wird angenommen, dass der Lichtbogen vorhanden ist. Diese Art der Erkennung ist jedoch lediglich dann möglich, wenn der geführte elektrische Strom im fehlerfreien Fall im Wesentlichen nur hochfrequente Anteile in schmalen Frequenzbändern aufweist, wie dies zum Beispiel bei Fotovoltaikanlagen der Fall ist, bei denen die Photovoltaikmodule die Spannungsquelle und ein elektrisch damit verbundener Wechselrichter die Last darstellt. Falls jedoch der mittels der Leitung geführte elektrischen Strom aufgrund einer hohen Anzahl von im Netz befindlichen getakteten leistungselektronischen Komponenten deutliche hochfrequente Anteile in sehr vielen gleichbleibenden Frequenzbändern aufweist oder in der Frequenz wechselnde hochfrequente Anteile (bei Pulsfrequenzmodulation) auftreten, ist dieses Verfahren zum Erkennen von seriellen Lichtbögen nur eingeschränkt möglich. Es ist erforderlich, für jeden der möglichen Betriebszustände die aufgrund des Betriebs der Komponenten vorhandenen hochfrequenten Anteile zu bestimmen und diese bei dem Erkennen des Lichtbogens zu berücksichtigen. Je mehr getaktete Komponenten und Betriebszustände vorhanden sind, desto komplexer wird das Verfahren. Dabei ist es erforderlich bei jeder Änderung/Anpassung einer der Komponenten das Verfahren entsprechend anzupassen.

Bei einer Variante wird jeweils der zu einer der Lasten geführte elektrische Strom erfasst und auf hochfrequente Anteile untersucht. Die dann vorhandenen hochfrequenten Anteile ergeben sich dabei lediglich aufgrund des Betriebs der jeweiligen Last. Jedoch ist bei dieser Abwandlung eine vergleichsweise große Anzahl von Sensoren zum Erfassen des jeweiligen elektrischen Stroms vorhanden, was eine Fehleranfälligkeit erhöht.

Das Dokument CN107024644A beschreibt ein Niederspannungs-Laborsystem zur Simulation einer unkompensierten Höchstspannungsleitung bei Erdschluss. Es erzeugt einen induktiven Kurzschlussstrom und einen nachgelagerten Sekundärlichtbogen, misst Spannung und Strom, erfasst Hochgeschwindigkeitsvideos und analysiert die Lichtbogenmorphologie mittels binärer Maskenbildverarbeitung.

Das Dokument US2012050933A1 beschreibt ein Schutzsystem für Zweigstromkreise, bei dem ein fest installierter Leistungshalbleiterschalter den Stromkreis sofort trennt, sobald ein Strom- oder Energieschwellenwert überschritten wird. Ein zweiter Strompfad mit einer transient-TVS-Komponent führt den Strom parallel zum Hauptpfad, sodass ein übergeordnetes Fehlererkennungsgerät den Fehler über diesen zweiten Pfad erkennen kann.

Der Erfindung liegt die Aufgabe zugrunde, ein besonders geeignetes Verfahren zum Erkennen eines seriellen Lichtbogens in einem Stromkreis, einen besonders geeigneten Schutzschalter, eine besonders geeignete Anlage und eine besonders geeignete Verwendung eines Schutzschalters anzugeben, wobei vorteilhafterweise eine Komplexität und Fehleranfälligkeit sowie ein Wartungsaufwand verringert ist.

Hinsichtlich des Verfahrens wird diese Aufgabe durch die Merkmale des Anspruchs 1, hinsichtlich des Schutzschalters durch die Merkmale des Anspruchs 9, hinsichtlich der Anlage durch die Merkmale des Anspruchs 12 und hinsichtlich der Verwendung durch die Merkmale des Anspruchs 14 erfindungsgemäß gelöst. Vorteilhafte Weiterbildungen und Ausgestaltungen sind Gegenstand der jeweiligen Unteransprüche.

Das Verfahren dient dem Erkennen eines seriellen Lichtbogens in einem Stromkreis. Hierbei weist der Stromkreis insbesondere eine Leitung auf, mittels derer eine Spannungsquelle mit einer Last verbunden ist. Der etwaige serielle Lichtbogen entsteht dabei insbesondere an der Leitung, zum Beispiel aufgrund einer Fehlerkontaktstelle, wie eines Kabelbruchs und/oder eines Lösens einer Steck-, Schraub- oder Klemmverbindung. Somit ist der Lichtbogen elektrisch zumindest abschnittsweise seriell zu einem Teil der Leitung, der Spannungsquelle, der Last und/oder einem weiteren Teil der Leitung geschaltet. Insbesondere entsteht dabei der serielle Lichtbogen, sofern diese vorhanden ist, aufgrund einer Ionisierung der sich in diesem Bereich befindenden Luft, sodass sich der Lichtbogen ausbildet. Dies erfolgt beispielsweise unmittelbar oder verzögert zum Entstehen der Fehlerkontaktstelle.

Mittels des Stromkreises wird beispielsweise ein Wechselstrom, jedoch besonders bevorzugt ein Gleichstrom geführt. Mit anderen Worten fließt der elektrische Strom, wenn dieser mittels der etwaigen Leitung geführt wird, lediglich in eine einzige Richtung und/oder mittels der etwaigen Spannungsquelle wird insbesondere eine Gleichspannung bereitgestellt. Die elektrische Spannung ist beispielsweise größer als 30 V und beträgt insbesondere 48 V. Geeigneterweise ist die elektrische Spannung kleiner als 1500 V oder kleiner als 800 V. Vorzugsweise ist die elektrische Spannung gleich 830 V oder 650 V, 380 V, 96 V oder 48 V. Beispielsweise ist der Stromkreis, insbesondere der Gleichstromkreis, ein Bestandteil eines Bordnetzes eines Kraftfahrzeugs, wie eines Personenkraftwagens (Pkw) oder Nutzkraftwagens, wie eines Lastkraftwagens (Lkw) oder Busses. Alternativ hierzu ist das Kraftfahrzeug beispielsweise eine Baumaschine oder ein landwirtschaftliches Gerät. In einer weiteren Ausbildung ist das Kraftfahrzeug ein Schiff, Boot oder Fluggerät, wie ein Flugzeug. Alternativ hierzu ist der Stromkreis, insbesondere sofern die anliegende elektrische Spannung größer als 100 V ist, ein Bestandteil einer Anlage, wie einer Kommunikationsanlage, eines Rechenzentrums oder einer Industrieanlage. In einer weiteren Alternativ ist die Anlage ein Bestandteil einer DC-Hausinstallation oder einer DC-versorgten Beleuchtungseinrichtung.

Der Stromkreis weist einen Hauptstrompfad mit einer Schalteinheit und einen hierzu parallelgeschalteten Nebenstrompfad mit einer Spannungssenke und einen Messpfad mit einem Stromsensor auf. Die Spannungssenke ist dabei insbesondere eine elektronische Baugruppe. Mit anderen Worten wirkt die elektronische Baugruppe als Spannungssenke. Beispielsweise sind hierbei der Hauptstrompfad, der Nebenstrompfad und der Messpfad jeweils ein Bestandteil eines Schutzschalters oder eines sonstigen Geräts des Stromkreises. Zum Beispiel sind die drei Pfade in einem gemeinsamen Gehäuse angeordnet, oder einer oder alle der Pfade sind auf unterschiedliche Gehäuse verteilt, die zum Beispiel benachbart oder beabstandet zueinander angeordnet sind. Die drei Pfade sind zweckmäßigerweise derart angeordnet, dass diese in einer gemeinsamen Richtung von dem elektrischen Strom durchflossen werden, also von der Spannungsquelle zur Last oder entgegengesetzt. Beispielsweise schließt sich der Messpfad direkt an den Hauptstrompfad und den Nebenstrompfad an, die somit direkt gegen diesen geführt sind. Alternativ hierzu sind beispielsweise noch weitere Bestandteile oder zumindest ein Teil der etwaigen Leitung des Stromkreises zwischen dem Messpfad und dem Hauptstrompfad/Nebenstrompfad angeordnet.

Die drei Pfade (Hauptstrompfad, Nebenstrompfad, Messpfad) sind insbesondere nicht zwingend für den Betrieb des Stromkreises erforderlich und/oder vorzugsweise zumindest teilweise in die etwaige Leitung eingebracht, mittels derer die Spannungsquelle mit der etwaigen Last oder den etwaigen Lasten verbunden ist. Mit anderen Worten dienen die Pfade im Wesentlichen dem Leiten des elektrischen Stroms. Dabei bilden die Pfade zum Beispiel bei einem unidirektionalen Stromfluss als Hinleiter oder Rückleiter zu der Last. Falls das Verfahren nicht durchgeführt werden soll, ist es möglich die Pfade durch jeweils einen niederohmigen Leiter zu ersetzen. Infolgedessen ist es auch möglich, das Verfahren bei einem bereits bestehen Stromkreis durchzuführen, nämlich indem entsprechende Abschnitte der etwaigen Leitung durch die jeweiligen Pfade ersetzt werden. Mit anderen Worten ist ein Nachrüsten möglich.

Die Schalteinheit des Hauptstrompfads ist geeignet, insbesondere vorgesehen und eingerichtet, eine elektrische Leitfähigkeit, insbesondere einen ohmschen Widerstand, des Hauptstrompfads zu verändern. Dabei ist es insbesondere möglich, die Schalteinheit zu öffnen oder zu schließen. Wenn die Schalteinheit geöffnet ist, ist kein elektrischer Stromfluss über den Hauptstrompfad möglich. Beispielsweise ist hierbei der Hauptstrompfad mechanisch aufgetrennt, sodass dessen Enden insbesondere galvanisch getrennt sind. Alternativ liegt keine galvanische Trennung vor. Falls hingegen die Schalteinheit geschlossen ist, ist der Hauptstrompfad elektrisch leitfähig und insbesondere sind die Enden des Hauptstrompfads niederohmig miteinander verbunden.

Mittels der Spannungssenke des Nebenstrompfads wird bei Betrieb, also wenn an dem Enden des Nebenstrompfad eine bestimmte (elektrische) Spannung anliegt bzw. über den Nebenstrompfad ein bestimmter elektrischer Strom fließt, ein bestimmter elektrischer Spannungsabfall hervorgerufen. Dieser ist dabei insbesondere näherungsweise unabhängig von dem über den Nebenstrompfad anfänglich fließenden elektrischen Strom und/oder der daran anliegende Spannung. Aufgrund der Parallelschaltung des Nebenstrompfad zu dem Hauptstrompfad wirkt dabei die Spannungssenke im Wesentlichen lediglich dann, wenn die Schalteinheit geöffnet ist. Falls hingegen die Schalteinheit geschlossen ist, ist aufgrund des niederohmigen Hauptstrompfads ein Einfluss der Spannungssenke auf den Stromkreis im Wesentlichen vernachlässigbar.

Der Stromsensor des Messpfads ist beispielsweise kontaktlos ausgestaltet und umfasst zum Beispiel ein Hallsensor oder magnetoresisitven Sensor. Alternativ oder in Kombination hierzu umfasst der Stromsensor insbesondere einen Shunt. In diesem Fall wird eine über eine Messstrecke des Shunts anfallende elektrische Spannung erfasst und hieraus, unter Zuhilfenahme des bekannten ohmschen Widerstands der Messstrecke oder eines Widerstands des Shunts, ein mittels des Messpfads geführte elektrische Strom ermittelt. Aufgrund der Anordnung des Messpfads wird daher auch der über den Hauptstrompfad geführte elektrische Strom erfasst, falls die Schalteinheit geschlossen ist. Falls hingegen die Schalteinheit geöffnet ist, wird mittels des Stromsensors der mittels des Nebenstrompfads geführte elektrische Strom erfasst.

Das Verfahren sieht vor, dass für einen ersten Zeitraum die Schalteinheit geöffnet wird. Somit ist vor und nach dem ersten Zeitraum die Schalteinheit insbesondere geschlossen. Aufgrund des Öffnens der Schalteinheit kommutiert ein mittels des Hauptstrompfads geführter elektrischer Strom auf den Nebenstrompfad, sodass die Spannungssenke diesen beeinflusst. Mittels des Stromsensors wird der während des ersten Zeitraums von dem Messpfad geführte elektrische Strom erfasst, der insbesondere auch dem über den Nebenstrompfad geführten elektrischen Strom entspricht. Aus dem erfassten elektrischen Strom, insbesondere den zu dem elektrischen Strom korrespondierenden Messdaten, wird ein Referenzsignal erstellt, das auch als Mustersignal bezeichnet wird. Zweckmäßigerweise wird mittels des Stromsensors auch bereits vor dem ersten Zeitraum der mittels des Messpfads geführte elektrische Strom erfasst, und das Referenzsignal auch anhand dieses Teils des erfassten elektrischen Stroms erstellt. Insbesondere beträgt dabei dieser zusätzliche Zeitabschnitt bis zu 1ms, 0,5ms oder0,1 ms. Folglich ist in dem Referenzsignal auch das Verhalten des elektrischen Stroms bei dem Kommutieren des elektrischen Stroms, nämlich dem Zuschalten der Spannungssenke, enthalten. Beispielsweise wird das Referenzsignal anhand des vollständigen während des ersten Zeitfensters erfassten elektrischen Stroms erstellt, sodass die Länge des Referenzsignal im Wesentlichen gleich der Länge des ersten Zeitraums ist. Besonders bevorzugt jedoch wird lediglich ein Teil hiervon verwendet, insbesondere lediglich bis zu 0,1 ms, 0,5 ms oder 1 ms. Vorzugsweise korrespondiert das Referenzsignal zu dem elektrischen Strom, der zu Beginn des ersten Zeitraums, als nach Öffnen der Schalteinheit, fließt. Insbesondere korrespondiert das Referenzsignal zu dem elektrischen Strom während der erste 1 ms oder 0,5 ms des ersten Zeitraums. Zusammenfassend wird das Referenzsignal zweckmäßigerweise anhand des elektrischen Stroms erstellt, der sich aufgrund der zugeschalteten Spannungssenke ergibt.

In einem weiteren Arbeitsschritt wird für einen zweiten Zeitraum, der nach dem ersten Zeitraum liegt, der von dem Messpfad geführte elektrische Strom erfasst. Beispielsweise schließt sich hierbei der zweite Zeitraum direkt an den ersten Zeitraum an, oder es ist noch ein weiterer Zeitraum dazwischen. Während des zweiten Zeitraums ist die Schalteinheit geschlossen, sodass mittels des Hauptstrompfads der elektrische Strom geführt wird. Aus dem erfassten elektrischen Strom wird ein Testsignal erstellt. Die Länge des Testsignal ist hierbei insbesondere gleich der Länge des Referenzsignals.

Das Testsignal wird mit dem Referenzsignal verglichen. Wenn eine Abweichung zwischen dem Testsignal und dem Referenzsignal kleiner als ein Grenzwert ist, wird der serielle Lichtbogen erkannt. Anderenfalls ist insbesondere kein serieller Lichtbogen erkannt. Mit anderen Worten wird angenommen, dass (zumindest nicht zwingend) der serielle Lichtbogen vorhanden ist.

Falls ein serieller Lichtbogen vorhanden ist, verhält sich in dieser zu Beginn von dessen Ausbildung im Wesentlichen wie eine Spannungssenke. Dieses Verhalten wird in dem ersten Zeitraum nachgeahmt, wobei anhand des dann vorhandenen elektrischen Stroms das Referenzsignal erstellt wird. Falls in dem zweiten Zeitraum somit ein ähnliches Muster auftritt, also eine unerwartete Spannungssenke vorhanden ist, ist somit der serielle Lichtbogen erkannt. Zum Erkennen des seriellen Lichtbogens ist dabei keine vergleichsweise komplizierte Bewertung, wie eine Fouriertransformation, des in dem zweiten Zeitraum erfassten elektrischen Stroms erforderlich, sondern dies erfolgt insbesondere im Zeitraum. Somit ist eine Komplexität und Fehleranfälligkeit verringert. Da zudem ein Vorliegen eines seriellen Lichtbogens mittels der Spannungssenke simuliert wird, ist das Referenzsignal auf die aktuelle Konfiguration des Stromkreises und/oder einer den Stromkreis aufweisenden Baueinheit, wie der etwaigen Anlage, abgestimmt sowie auf den jeweiligen Betriebspunkt, der zumindest während des ersten Zeitraums vorherrscht. Somit ist eine unkomplizierte Anpassbarkeit an unterschiedlichste Gegebenheiten ermöglicht. Auch ist hierbei kein Überwachen jeder Last erforderlich, falls mehrere vorhanden sind, weswegen Hardwareanforderungen reduziert sind.

Beispielsweise wird das Verfahren lediglich zur Überprüfung des Stromkreises verwendet. Besonders bevorzugt jedoch wird anhand des Verfahrens eine Sicherungsvorrichtung betrieben, mittels derer bei Vorliegen des seriellen Lichtbogens eine Sicherungsmaßnahme durchgeführt wird, um eine (weitere) Beschädigung des Stromkreises zu vermeiden. Zweckmäßigerweise wird als Sicherungsvorrichtung ein Schutzschalter herangezogen, der zumindest teilweise gemäß dem Verfahren betrieben wird. Der Schutzschalter dient insbesondere der Absicherung, also dem Schutz, einer elektrischen Leitung und/oder einer Komponente, wie eines Geräts. Mit anderen Worten handelt sich bei dem Schutzschalter somit um einen Leitungsschutzschalter bzw. einen Geräteschutzschalter.

Falls beispielsweise die Schalteinheit vergleichsweise träge ist, wird der gefilterte elektrische Strom zum Erstellen des Referenzsignals und/oder des Testsignals verwendet. Insbesondere wird hierfür ein Tiefpassfilter herangezogen. Geeigneterweise ist der zweite Zeitraum größer als der erste Zeitraum, sodass entstehende elektrische Verluste aufgrund der Spannungssenke verringert sind.

Zum Beispiel wird während des zweiten Zeitraums lediglich ein einziges Testsignal erstellt, das dann mit dem Referenzsignal verglichen wird. Das Testsignal korrespondiert dabei beispielsweise zu dem am Anfang des zweiten Zeitraums vorhandenen elektrischen Strom. Alternativ hierzu wird der erfasste elektrische Strom des zweiten Zeitraums auf das Vorliegen einer Bedingung überprüft. Das Vorliegen der Bedingung führt dabei insbesondere zum Beginn des Erstellens des Testsignals gegeben. Die Bedingung ist dabei insbesondere erfüllt, falls der elektrische Strom Unter eine bestimmte Schwelle absinkt, und/oder wenn eine Änderung des Stroms, insbesondere der Absolutbetrag einer Steigung der Änderung bei einem Absinken, größer als eine entsprechend angepasste Schwelle ist.

In einer Alternative werden während des zweiten Zeitraums mehrere derartige Testsignal erstellt, wobei diese zum Beispiel stets in einem bestimmten zeitlichen Abstand starten. Insbesondere ist der Stromsensor getaktet betrieben, sodass der elektrische Strom lediglich zu bestimmten, diskreten Zeitpunkten erfasst wird.

Dabei beginnt beispielsweise mit jedem Zeitpunkt eines der Testsignale. Bei dieser Vorgehensweise wird zweckmäßigerweise jedes der Testsignale mit dem Referenzsignal verglichen.

In einer Weiterbildung wird zusätzlich zu dem elektrischen Strom die über den Hauptstrompfad und somit auch über den Nebenstrompfad anfallende elektrische Spannung erfasst. Anhand der in dem ersten Zeitraum erfassten elektrischen Spannung wird insbesondere ein weiteres Referenzsignal erstellt, und anhand der in dem zweiten Zeitraum erfassten elektrischen Spannung wird ein entsprechendes weiteres Testsignal. Auch diese werden miteinander verglichen. Beispielsweise wird der serielle Lichtbogen lediglich dann erkannt, wenn zudem das weitere Referenzsignal um weniger als einen weiteren Grenzwert von dem weiteren Testsignal abweicht.

Beispielsweise wird der erste Zeitraum und/oder der zweite Zeitraum lediglich gestartet, wenn eine (jeweilige) bestimmte Bedingung vorliegt. Vorzugsweise werden der erste Zeitraum und der zweite Zeitraum mehrmals gestartet. Dabei wird der erste Zeitraum oder der zweite Zeitraum beispielsweise lediglich dann gestartet, wenn eine jeweilige Bedingung erfüllt ist. Alternativ hierzu ist zwischen dem zweiten Zeitraum und dem darauffolgenden erste Zeitraum ein weiterer Zeitraum vorhanden, der insbesondere konstant oder variabel ist. In dem weiteren Zeitraum wird beispielsweise der elektrische Strom mittels des Stromsensors nicht erfasst. Besonders bevorzugt jedoch wird nach dem zweiten Zeitraum im Wesentlichen unverzüglich erneut der erste Zeitraum gestartet, sodass ein neues Referenzsignal erstellt wird. Insbesondere ist die Zeit, die der Stromkreis betrieben ist, in sich abwechselnde erste und zweite Zeiträume unterteilt. Somit erfolgt im Wesentlichen eine kontinuierliche Überwachung auf den seriellen Lichtbogen, die lediglich zur Erstellung eines jeweiligen neuen Referenzsignals unterbrochen ist. Auf diese Weise ist eine Sicherheit erhöht. Da zudem im Wesentlichen kontinuierlich das Referenzsignal neu erstellt wird, erfolgt eine adaptive Anpassung auf den jeweiligen Zustand des Stromkreises, insbesondere auf einen jeweiligen Betriebszustand und/oder eine Konfiguration. Mit anderen Worten ist das Verfahren somit an den jeweiligen Betrieb des Stromkreises adaptiert, wobei kein genaues Wissen um die aktuelle, tatsächliche Konfiguration des Stromkreises, insbesondere dessen Komponenten und/oder deren Arbeits-/Betriebspunkte, erforderlich ist. Somit ist ein Aufwand und eine Fehleranfälligkeit reduziert und zudem ein Wartungsbedarf verringert.

Beispielsweise entspricht die Länge des zweiten Zeitraums der Länge des Zeitraums, den der Stromkreis betrieben wird, abzüglich des ersten Zeitraums, insbesondere sofern lediglich einmalig das Referenzsignal erstellt wird. Besonders bevorzugt jedoch ist die Länge des zweiten Zeitraums zwischen 0,1 Sekunden und 20 Sekunden oder zwischen 0,5 Sekunden und 10 Sekunden, wobei zweckmäßigerweise nach Ende des zweiten Zeitaufwands jeweils der erste Zeitraum gestartet wird. Somit ist der zeitliche Abstand zu dem jeweiligen Zeitpunkt, zu dem das Referenzsignal erstellt wurde, das während des zweiten Zeitraums verwendet wird, vergleichsweise kurz. Daher ist eine etwaige Änderung des Betriebs des Stromkreises lediglich gering, die zu einem veränderten elektrischen Strom führen kann, weswegen eine Genauigkeit beim Erkennen des seriellen Lichtbogens verbessert ist. Aufgrund dieser Länge des zweiten Zeitraums ist für vergleichsweise lange Zeit ein Betrieb des Stromkreises möglich, ohne dass das Betriebsverhalten übermäßig beeinflusst wird.

Alternativ oder in Kombination hierzu wird eine Länge des ersten Zeitraums zwischen 0,1 ms und 10 ms gewählt. Somit ist der Zeitraum, in dem aufgrund der Spannungssenke zusätzliche elektrische Verluste auftreten, vergleichsweise kurz. Nach einer Zeit von ca. 10ms treten zudem bei einem Lichtbogen und/oder bei der Spannungssenke unterschiedliche nichtlineare Effekte auf. Mit anderen Worten unterscheiden sich dann insbesondere die Auswirkungen der Spannungssenke und des seriellen Lichtbogens auf den Stromkreis und die Stromverläufe können sich insbesondere vergleichsweise stark unterscheiden. Bei einer größeren Länge des ersten Zeitraums wäre somit eine Erkennung des seriellen Lichtbogens erschwert. Beispielsweise ist der erste Zeitraum konstant, was einen Aufwand verringert. Alternativ hierzu wird der erste Zeitraum, insbesondere sofern das Verfahren kontinuierlich durchgeführt oder zumindest der erste Zeitraum mehrmals gestartet wird, adaptiv angepasst. Insbesondere wird dieser bis zu dem Zeitpunkt verkürzt, ab dem ein im Wesentlichen konstanter elektrischer Strom geführt wird.

Zweckmäßigerweise ist die Länge des ersten Zeitraums oder zumindest des Referenzsignals derart gewählt, dass in diesem der erfasste elektrische Strom oder zumindest das Referenzsignal/Testsignal verschieden von 0 sind. Falls dahingegen bei einem davon 0 oder zumindest ein zu 0 A korrespondierender elektrischer Strom erreicht wird, wird der Vergleich zwischen dem Referenzsignal und dem Testsignal lediglich bis zu diesem Zeitpunkt durchgeführt, auch wenn das Referenzsignal/Testsignal eine größere Länge aufweist. Somit werden insbesondere Artefakte vermieden, die zu einem Nichterkennen eines entsprechenden seriellen Lichtbogens führen würden.

Beispielsweise wird der erste Zeitraum stets dann gestartet, wenn eine bestimmte Vorgabe vorliegt, wie beispielsweise, dass der zweite Zeitraum abgelaufen ist, oder die etwaige bestimmte Bedingung vorliegt. Besonders bevorzugt jedoch wird zudem überprüft, ob eine Veränderung des von dem Messpfad geführten elektrischen Stroms geringer als ein zweiter Grenzwert ist. Mit anderen Worten wird der erste Zeitraum somit lediglich dann gestartet, wenn die Veränderung des von dem Messpfad geführten elektrischen Stroms geringer als der zweite Grenzwert ist, wobei der elektrische Strom mittels des Stromsensors erfasst wird. Insbesondere wird hierfür eine Varianz oder eine Standardabweichung des elektrischen Stroms bestimmt und mit dem entsprechenden zweiten Grenzwert verglichen, der entsprechend angepasst ist. Falls beispielsweise der serielle Lichtbogen bereits vorliegt und noch nicht erkannt wurde, oder falls eine Umkonfiguration des Stromkreises erfolgt, insbesondere eine Änderung des Betriebspunkts, ergeben sich entsprechende Veränderungen in dem elektrischen Strom. Falls zu diesem Zeitpunkt das Referenzsignal erstellt würde, sind entsprechende Effekte vorhanden, die im nachfolgenden zweiten Zeitraum nicht mehr vorliegen. Somit unterscheidet sich das Referenzsignal von einem Testsignal, wenn der serielle Lichtbogen vorhanden ist. Zusammenfassend ist eine Genauigkeit beim Erkennen des seriellen Lichtbogens verbessert, da Übergangszustände des Stromkreises, bei denen eine entsprechende Veränderung in dem elektrischen Strom vorliegen, nicht bei der Erstellung des Referenzsignals berücksichtigt werden. Aufgrund des Unterlassens des Startens des ersten Zeitraums bei der etwaigen Umkonfiguration des Stromkreises ist ferner kein Einfluss der Spannungssenke vorhanden, weswegen die Umkonfiguration vergleichsweise schnell abgeschlossen ist.

Beispielsweise wird der in dem ersten Zeitraum erfasste elektrische Strom direkt als das Referenzsignal herangezogen. Somit ist ein vergleichsweise schnelles Bestimmen des Referenzsignals ermöglicht. Besonders bevorzugt jedoch wird zum Erstellen des Referenzsignals die Ableitung des elektrischen Stroms verwendet. Aufgrund der Verwendung der Ableitung ist die Höhe des elektrischen Stroms ohne Bedeutung, sodass das Verfahren auch bei unterschiedlichen Belastungen des Stromkreises verwendet werden kann. Mit anderen Worten sind unterschiedlichen Betriebszustände unerheblich, und falls während des ersten Zeitraums ein Betrieb der etwaigen Last mit einer unterschiedlichen Leistung erfolgte als während des zweiten Zeitraums, wird dennoch sicher der etwaige serielle Lichtbogen erkannt.

Sofern der elektrische Strom lediglich zu diskreten Zeitpunkten erfasst wird, wird zum Erstellen der Ableitung somit stets der jeweils aktuelle Wert des elektrischen Stroms von dem zeitlich vorhergehenden Wert abgezogen, insbesondere nach einer Filterung/Messrauschunterdrückung. Alternativ hierzu wird ein Stromsensor herangezogen, mittels dessen direkt die Ableitung des elektrischen Stroms oder ein bandbegrenzter AC-Anteil des elektrischen Stroms erfasst wird. Zweckmäßigerweise wird hierbei als Stromsensor ein Sensor basierend auf dem transformatorischen Prinzip herangezogen, der insbesondere einen Ringkern aufweist. Somit sind Herstellungskosten reduziert.

Beispielsweise wird lediglich die Ableitung des erfassten elektrischen Stroms als Referenzsignal herangezogen. Besonders bevorzugt jedoch wird die skalierte Ableitung als Referenzsignal herangezogen. Mit anderen Worten wird die Ableitung mit einem bestimmten Faktor multipliziert, der beispielsweise 1 ("eins") oder besonders bevorzugt unterschiedlich hiervon ist. Die Skalierung erfolgt beispielsweise vor, nach und/oder bei Erstellen der Ableitung des erfassten elektrischen Stroms. Vorzugsweise erfolgt die Skalierung in Abhängigkeit einer Zeitauflösung des verwendeten Stromsensors. Zweckmäßigerweise erfolgt die Skalierung in Abhängigkeit der jeweils verwendeten Spannungssenke. Dabei wird als Faktor zweckmäßigerweise das Verhältnis der bei einem seriellen Lichtbogen auftretenden elektrischen Spannung, die zwischen 13 V und 15 V beträgt, mit dem Wert der Spannung ins Verhältnis gesetzt, die mittels der Spannungssenke hervorgerufen wird. In einer Weiterbildung wird zu der skalierten Ableitung eine bestimmte Konstante addiert.

Fall für die Spannungssenke ein Wert gewählt worden ist, der deutlich unter dem anfänglichen Spannungsabfall eines potenziellen Lichtbogens liegt, wird das Referenzsignal zweckmäßigerweise zunächst kalibriert, also die Skalierung durchgeführt. Der Kalibrierungs-/Skalierungsfaktor ist dabei der Quotient aus 14 V und dem Wert der gewählten Spannungssenke. Bei der Skalierung/Kalibrierung wird dabei bei direkter Verwendung zweckmäßigerweise vom Referenzsignal zunächst der Anfangswert abgezogen, das Ergebnis mit dem Faktor multipliziert und wieder der Anfangswert addiert. Wird zweckmäßigerweise die Ableitung des elektrischen Stroms verwendet, genügt beispielsweise die Multiplikation mit dem Faktor.

Zweckmäßigerweise ist das Testsignal auf die Art des verwendeten Referenzsignals angepasst, und als Testsignal wird zweckmäßigerweise die Ableitung des erfassten elektrischen Stroms herangezogen. Auf diese Weise ist ein Ermitteln des Testsignals innerhalb einer vergleichsweise kurzen Zeitspanne möglich, sodass der serielle Lichtbogen vergleichsweise schnell erkannt wird. Aufgrund der Skalierung des Referenzsignals entspricht des Testsignal dem Referenzsignal im Wesentlichen, wenn der serielle Lichtbogen vorliegt, und der entsprechende Faktor ist vorzugsweise hierauf angepasst. Sofern mehrere Testsignale mit dem Referenzsignal verglichen werden, ist ein Aufwand verringert.

Zweckmäßigerweise wird zum Ermitteln der Abweichung zu diskreten Zeitpunkten die Differenz zwischen dem Referenzsignal und dem Testsignal erstellt. Insbesondere entsprechen oder korrespondieren die Zeitpunkte zu den Zeitpunkten, zu denen der elektrische Strom erfasst wurde, falls das Erfassen diskret erfolgt.

Alternativ oder in Kombination hierzu entsprechen/korrespondieren die Zeitpunkte den Zeitpunkten, zu denen das jeweilige Testsignal und Referenzsignal erstellt wurden, sodass eine vergleichsweise komplizierte Umrechnung nicht erforderlich ist. Die Zeitpunkte des Referenzsignals und des Testsignals sind zueinander insbesondere um mindestens die Länge des ersten Zeitraums zeitlich versetzt. Anhand der Differenzen wird die Abweichung erstellt. Besonders bevorzugt wird hierfür jede der Differenzen quadriert und diese addiert. Mit anderen Worten wird das sogenannte L2-Maß ermittelt und mit dem jeweils angepassten Grenzwert verglichen. Somit ist ein vergleichsweise robuster Vergleich bereitgestellt. Alternativ hierzu werden beispielsweise die Beträge der Differenzen erstellt, und hieraus das Maximum ermittelt. Dieses wird mit dem entsprechend angepasstem Grenzwert verglichen. Somit wird der serielle Lichtbogen erkannt, falls der zeitliche Verlauf des Testsignals in einem bestimmten Korridor um den zeitlichen Verlauf des Referenzsignals liegt, wobei die Breite des Korridors anhand des Grenzwerts vorgegeben ist. Somit ist ein Berechnungsaufwand verringert.

Beispielsweise weist die Schalteinheit lediglich einen mechanischen Schalter auf, der geöffnet wird. Beispielsweise ist der mechanische Schalter ein Relais oder besonders bevorzugt ein Schütz. Besonders bevorzugt umfasst die Schalteinheit einen Halbleiterschalter. Somit ist prinzipiell ein lichtbogenfreies Unterbrechen des elektrischen Stromflusses über den Hauptstrompfad ermöglicht, sodass das Referenzsignal nicht aufgrund eines etwaigen weiteren Lichtbogens beeinflusst wird. Insbesondere wird hierbei ein Halbleiterschalter herangezogen, mittels dessen ein vergleichsweise schnelles Schalten ermöglicht ist, sodass ein vergleichsweise schnelles Kommutieren des elektrischen Stroms von dem Hauptstrompfad auf den Nebenstrompfad erfolgt. Besonders bevorzugt umfasst die Schalteinheit den Halbleiterschalter und den hierzu parallelgeschalteten mechanischen Schalter. Beispielsweise ist die Schalteinheit lediglich aus dem mechanischen Schalter und dem Halbleiterschalter gebildet oder weist zusätzliche Bauteile auf. Zum Öffnen der Schalteinheit wird zunächst der mechanische Schalter der Schalteinheit und anschließend der Halbleiterschalter in den elektrisch nichtleitenden Zustand versetzt. Zum Versetzen in den elektrisch leitfähigen Zustand wird dabei zunächst der Halbleiterschalter geschlossen und anschließend der mechanische Schalter. Der Zeitpunkt, zu dem der erste Zeitraum gestartet wird, ist dabei der Zeitpunkt, zu dem der Halbleiterschalter geöffnet wird, also in den nicht elektrisch nichtleitenden Zustand versetzt wird.

Während des zweiten Zeitraums wird der von dem Hauptstrompfad geführte elektrische Strom auf den mechanischen Schalter und Halbleiterschalter aufgeteilt. Sofern beide sich in dem elektrisch leitenden Zustand befinden, erfolgt das Stromführen im Wesentlichen hauptsächlich mit dem mechanischen Schalter, da dieser einen geringeren internen Widerstand aufweist. Somit sind elektrische Verluste reduziert. Auch ist es somit möglich, einen Halbleiterschalter mit einer verringerten Spannungsfestigkeit zu verwenden, sodass Herstellungskosten reduziert sind. Zweckmäßigerweise ist der mechanische Schalter hierbei derart ausgebildet, dass dieser, sofern keine anderweitige Ansteuerung erfolgt, geschlossen ist. Somit sind entstehende elektrische Verluste weiter reduziert.

Der Schutzschalter dient der Absicherung gegen einen seriellen Lichtbogen und ist hierfür geeignet, insbesondere vorgesehen und eingerichtet. Dabei weist der Schutzschalter einen Hauptstrompfad mit einer Schalteinheit und einen hierzu parallel geschalteten Nebenstrompfad mit einer Spannungssenke auf. Zudem weist der Schutzschalter einen Messpfad mit einem Stromsensor und einem Schalter auf. Dabei ist der Messpfad elektrisch in Reihe zu dem Hauptstrompfad und dem Nebenstrompfad geschaltet. Beispielsweise sind hierbei der Stromsensor und der Schalter in einem zusammenhängenden Stück des Messpfads angeordnet. Alternativ hierzu ist der Messpfad unterbrochen, und zwischen den beiden Stücken des Messpfads sind insbesondere der Nebenstrompfad und der Hauptstrompfad angeordnet. Beispielsweise sind der Hauptstrompfad und der Nebenstrompfad in einem gemeinsamen Gehäuse angeordnet, wobei der Messpfad in einem oder mehreren hierzu separaten Gehäusen angeordnet ist. Bevorzugt jedoch ist der Schutzschalter in einem einzigen Gehäuse angeordnet, was eine Montage erleichtert.

Der Schalter ist beispielsweise ein mechanischer Schalter, wie ein Relais oder Schütz, oder ein Halbleiterschalter. Besonders bevorzugt jedoch umfasst der Schalter mehrere Schaltelemente, beispielsweise den mechanischen Schalter und den Halbleiterschalter, die beispielsweise zueinander elektrisch parallel oder elektrisch in Reihe geschaltet sind. Insbesondere ist der Schalter derart ausgebildet, dass mittels dessen ein lichtbogenfreies Schalten zum Unterbrechen eines Stromflusses über den Schutzschalter ermöglicht ist.

Der Schutzschalter ist gemäß einem Verfahren betrieben, bei dem zunächst ein Verfahren durchgeführt wird, um einen seriellen Lichtbogen zu erkennen. Bei diesem wird für einen ersten Zeitraum die Schalteinheit geöffnet und mittels des Stromsensors der von dem Messpfad geführte elektrische Strom erfasst und hieraus ein Referenzsignal erstellt. Für einen zweiten Zeitraum, in dem die Schalteinheit geschlossen ist, wird der von dem Messpfad geführte elektrische Strom erfasst und hieraus ein Testsignal erstellt. Das Testsignal wird mit dem Referenzsignal verglichen, wobei der serielle Lichtbogen erkannt wird, wenn eine Abweichung zwischen dem Testsignal und dem Referenzsignal kleiner als ein Grenzwert ist. Wenn der serielle Lichtbogen erkannt wurde, wird der Schalter betätigt, sodass der Messpfad aufgetrennt wird. Infolgedessen ist ein Stromfluss über den Schutzschalter unterbunden. Zusammenfassend ist der Schutzschalter ausgebildet, den Schalter zu betätigen, wenn der serielle Lichtbogen erkannt wurde.

Vorzugsweise weist der Schutzschalter eine Steuereinheit auf, mittels derer das Verfahren zumindest teilweise durchgeführt wird. Mit anderen Worten ist die Steuereinheit hierfür geeignet, insbesondere vorgesehen und eingerichtet. Die Steuereinheit ist beispielsweise als anwendungsspezifischer Schaltkreis (ASIC) ausgestaltet oder umfasst einen Mikroprozessor, der insbesondere programmierbar ist.

Der Schutzschalter ist vorzugsweise zur Gleichstromunterbrechung ausgestaltet und zum Beispiel lediglich unidirektional oder besonders bevorzugt bidirektional. Besonders bevorzugt ist eine maximal mittels des Schutzschalters schaltbare elektrische Spannung größer als 40 V, 100 V, 200 V oder 500 V. Zum Beispiel ist die maximal mittels des Schutzschalters schaltbare elektrische Spannung kleiner als 1500 V oder 1000 V. Hierfür ist der Schutzschalter jeweils geeignet, insbesondere vorgesehen und eingerichtet. Zum Beispiel ist der Schutzschalter zum Schalten einer elektrischen Spannung von 1000 V vorgesehen, und/oder einem Schalten eines elektrischen Stroms von mehreren 10 A, also beispielsweise 20 A, 40 A, 60 A, 80 A oder 100A. Hierfür ist der Schutzschalter zweckmäßigerweise jeweils geeignet, vorzugsweise eingerichtet.

Beispielsweise wird der Schutzschalter in einem Kraftfahrzeug verwendet, insbesondere in einem Bordnetz, mittels dessen ein elektrischer Gleichstrom geführt ist. Besonders bevorzugt ist der Schutzschalter ein Bestandteil eines Hochvoltbordnetz des Kraftfahrzeugs und dient insbesondere der Absicherung einer Hochvoltbatterie und/oder eines Elektromotors eines Kraftfahrzeugs, mittels dessen insbesondere ein Antrieb erfolgt. Das Kraftfahrzeug ist beispielsweise ein Schiff, Boot oder Luftfahrzeug. Besonders bevorzugt jedoch ist das Kraftfahrzeug landgebunden und zum Beispiel schienengeführt. Das Kraftfahrzeug ist in diesem Fall beispielsweise ein Triebwagen, eine Lokomotive, ein Zug oder eine Straßenbahn. Alternativ ist das Kraftfahrzeug unabhängig von Schienen oder dergleichen bewegbar. Zweckmäßigerweise ist das Kraftfahrzeug ein Personenkraftwagen (Pkw) oder besonders bevorzugt ein Nutzkraftwagen, wie zum Beispiel ein Bus oder ein Lastkraftwagen (Lkw). Alternativ ist der Schutzschalter für den industriellen Bereich vorgesehen und beispielsweise im Montagezustand ein Bestandteil einer Anlage, wie einer Industrieanlage. Alternativ hierzu ist die Anlage ein Rechenzentrum oder eine Telekommunikationsanlage. In einer weiteren Alternativ ist dient die Anlage der Beleuchtung und weist eine oder mehrere Lampen auf. Zum Beispiel ist die Anlage ein Bestandteil eines Gebäudes, oder die Lampen sind Straßenlampen/Straßenlaternen.

Beispielsweise weist der Schutzschalter noch weitere Sensoren auf, und bei Betrieb werden weitere Verfahren zum Erkennen eines jeweiligen Fehlerfalls durchgeführt. Als Fehlerfall wird insbesondere ein Überstrom, insbesondere Kurzschlussstrom, herangezogen. Falls ein entsprechender Fehlerfall erkannt wurde, wird ebenfalls der Schalter betätigt. Alternativ oder in Kombination hierzu umfasst der Schutzschalter beispielsweise eine Vorladeschaltung, was einen Einsatzbereich des Schutzschalters vergrößert.

Beispielsweise umfasst der Schutzschalter lediglich eine einzige Sensoreinheit als Stromsensor. Alternativ hierzu umfasst der Stromsensor mehrere Sensoreinheiten, beispielsweise einen mittels dessen der elektrische Strom über einen vergleichsweise großen Wertebereich erfasst werden kann, wobei jedoch eine Genauigkeit verringert ist. Insbesondere wird diese Sensoreinheit herangezogen, um zu bestimmen, ob das Verfahren zum Erkennen des seriellen Lichtbogens gestartet werden kann. Die andere Sensoreinheit wird zum Durchführen des Verfahrens verwendet, und weist zumindest in dem Bereich des erwarteten Testsignals/Referenzsignals eine verbesserte Genauigkeit auf, also insbesondere in einem Nennbereich des Schutzschalters. Alternativ hierzu wird als einer der Sensoreinheit ein DC-Stromsensor und als die andere ein AC-Stromsensor verwendet, der insbesondere einen nanokristallinen Ringkern mit hoher Gleichstrombelastbarkeit zur Vermeidung von Sättigungseffekten aufweist. Der DC-Stromsensor diente dabei der Abschätzung des Gleichstromanteils, und mittels des anderen wird das Referenzsignal / Testsignal erstellt. Hierbei erfolgt insbesondere eine, vorzugsweise sensorimmanente, Bandpassfilterung der mittels des AC-Stromsensors erstellten Messsignale bevor das jeweilige Referenz-/Testsignal erstellt wird. Insbesondere ist der Stromsensor derart aufgebaut.

Beispielsweise umfasst die Spannungssenke eine Zener-Diode (Z-Diode), einen Varistor oder ist aus diesen jeweils gebildet. Falls der Schutzschalter lediglich unidirektional eingesetzt wird, ist dabei beispielsweise lediglich eine Zener-Diode vorhanden. Falls der Schutzschalter bidirektional verwendet werden soll, sind insbesondere zwei gegenläufig verschaltete Zener-Dioden vorhanden.

Besonders bevorzugt jedoch umfasst die Spannungssenke eine Suppressordiode (TVS-Diode) und ist beispielsweise mittels dieser gebildet. Die Suppressordiode ist hierbei insbesondere derart angeordnet, dass dies entgegen der Sperrrichtung betrieben wird. Die Durchlassspannung oder Durchbruchspannung ist dabei zweckmäßigerweise zwischen 5 V und 20 V. Somit wird diese Spannung jeweils mittels der Spannungssenke bereitgestellt, falls über den Nebenstrompfad der elektrische Stromfluss erfolgt. Eine Suppressordiode kann bei vergleichsweise hohen elektrischen Strömen verwendet werden und weist im Vergleich zu beispielsweise einer Zener-Diode eine vergleichsweise scharfe Kennlinie auf, sodass mittels der Spannungssenke im Wesentlichen stets die gleiche elektrische Spannung bereitgestellt wird, im Wesentlichen unabhängig von dem fließenden elektrischen Strom. Somit entspricht das Referenzsignal vergleichsweise genau dem Testsignal, falls der serielle Lichtbogen vorhanden ist. Falls der Schutzschalter lediglich unidirektional betrieben wird, ist beispielsweise lediglich die einzige, insbesondere unipolare, Suppressordiode vorhanden. Falls der Schutzschalter bidirektional betrieben werden soll, sind beispielsweise zwei gegenläufig zueinander orientierte unipolare Suppressordiode oder eine bipolar Suppressordiode vorhanden. Beispielsweise umfasst die Spannungssenke lediglich die einzige Suppressordiode, oder mehrere Suppressordioden, die beispielsweise zumindest teilweise elektrisch in Reihe und/oder elektrisch parallelgeschaltet sind. Somit ist es möglich, das Verhalten der Spannungssenke vergleichsweise genau zu modellieren und/oder kostengünstige Suppressordiode zu verwenden. Vorzugsweise sind dabei Vorwiderstände vorhanden, um den elektrischen Strom geeignet aufzuteilen.

Besonders bevorzugt umfasst der Nebenstrompfad einen Überstromschutz. Der Überstromschutz ist beispielsweise eine Sicherung, die elektrisch in Reihe mit der Spannungssenke geschaltet ist. Hierbei ist die Sicherung insbesondere als eine flinke Sicherung ausgestaltet. Mittels des Überstromschutzes wird dabei eine Zerstörung der Spannungssenke bei einem vergleichsweise hohen Strom, insbesondere einem Überstrom, vermieden. Insbesondere wird bei einem Erfassen eines derartigen Überstrom zudem der Schalter des Schutzschalters betätigt, sodass nachfolgend der elektrische Stromfluss über den Schutzschalter unterbrochen wird.

Die Anlage weist eine Spannungsquelle und mehreren Lasten auf, die mittels einer Leitung elektrisch verbunden sind. Mittels der Spannungsquelle wird zweckmäßigerweise eine Gleichspannung bereitgestellt. Die Leitung weist zweckmäßigerweise zwei Adern/ Kabel auf, von denen eine dem positiven und die andere einem negativen Pol der Spannungsquelle zugeordnet ist. Insbesondere umfasst die Leitung mehrere Leitungssegmente, die elektrisch in Reihe geschaltet sind. Mittels der Leitung sind die Lasten dabei beispielsweise teilweise elektrisch in Reihe und/oder parallel geschaltet.

Die Lasten sind insbesondere in Abhängigkeit der jeweils verwendeten Anlage angepasst und beispielsweise ein (Groß-) Rechner, eine Industriemaschine oder dergleichen. Insbesondere ist die Anlage somit eine Industrieanlage, ein Rechenzentrum oder eine Telekommunikationsanlage. Die Lasten sind dabei beispielsweise elektrisch in Reihe oder zumindest teilweise elektrisch parallelgeschaltet, und zumindest einige der Lasten können beispielsweise mit unterschiedlichen Betriebspunkten betrieben werden, also insbesondere mit einer unterschiedlichen bereitgestellten Leistung.

In die Leitung ist ein Schutzschalter eingebracht. Insbesondere bildet der Schutzschalter zumindest einen Abschnitt der Leitung. Vorzugsweise sind an den Schutzschalter zwei der etwaigen Kabel der Leitung angeschlossen. Der Schutzschalter umfasst einen Hauptstrompfad mit einer Schalteinheit, einen hierzu parallel geschalteten Nebenstrompfad mit einer Spannungssenke und einen Messpfad mit einem Stromsensor und einem Schalter. Der Messpfad ist elektrisch in Reihe zu dem Hauptstrompfad und dem Nebenstrompfad geschaltet. Der Schutzschalter ist ausgebildet, ein Verfahren zum Erkennen eines seriellen Lichtbogens durchzuführen, bei dem für einen ersten Zeitraum die Schalteinheit geöffnet und mittels des Stromsensors der von dem Messpfad geführte elektrische Strom erfasst und hieraus ein Referenzsignal erstellt wird. Für einen zweiten Zeitraum, in dem die Schalteinheit geschlossen ist, wird der von dem Messpfad geführte elektrische Strom erfasst und hieraus ein Testsignal erstellt. Das Testsignal wird mit dem Referenzsignal vergleichen, wobei der serielle Lichtbogen erkannt wird, wenn eine Abweichung zwischen dem Testsignal und dem Referenzsignal kleiner als ein Grenzwert ist. Ferner ist der Schutzschalter ausgebildet, den Schalter zu betätigen, wenn der serielle Lichtbogen erkannt wurde.

Beispielsweise ist der Schutzschalter zwischen der Spannungsquelle und sämtlichen Lasten angeordnet, sodass der von der Spannungsquelle zu jeder der Lasten geführte elektrische Strom stets über den Schutzschalter geführt wird, unabhängig, welche der Lasten in welche Art und Weise betrieben wird. In einer Alternative hierzu weist der Schutzschalter mehrere Hauptstrompfade auf, wobei zu jedem der Hauptstrompfade jeweils ein entsprechender Nebenstrompfad parallelgeschaltet ist. Mit anderen Worten weist der Schutzschalter somit mehrere Schalteinheiten und mehrere Spannungssenke auf.

Die Hauptstrompfade, und folglich auch die Nebenstrompfade, sind zueinander beabstandet. Insbesondere ist zwischen benachbarten Hauptstrompfaden jeweils eine der Lasten angeordnet, oder zumindest ist dazwischen eine Abzweigung zu einer der Lasten vorhanden. Beispielsweise ist jeder der Lasten ein entsprechender Hauptstrompfad zugeordnet. Mittels Betätigung der jeweiligen Schalteinheit ist es somit möglich, in jedem entsprechenden Teilstück der Leitung das Vorhandensein eines seriellen Lichtbogens zu simulieren. Mittels des Messpfads, der sich insbesondere im Bereich der Spannungsquelle befindet, werden die entsprechenden Auswirkungen erfasst, zweckmäßigerweise, indem ein entsprechendes Referenzsignal erstellt wird. Somit ist das was eine genaue Lokalisierung des seriellen Lichtbogens ermöglicht, falls dieser vorhanden ist.

Bei Betrieb ist jedem Hauptstrompfad insbesondere ein entsprechender erster Zeitraum zugeordnet, die sich vorzugsweise aneinander anschließen. Folglich werden mehrere Referenzsignal erstellt. Die Referenzsignale unterscheiden sich dabei aufgrund der entsprechenden Verschaltung der Anlage, also der Ausgestaltung der Leitung. Wenn sämtliche erste Zeiträume abgelaufen sind, wird geeigneterweise der zweite Zeitraum gestartet. In diesem wird das Testsignal erstellt, das mit jedem der Referenzsignal verglichen wird. Folglich wird überwacht, ob in einem der Teilbereiche der Leitung der serielle Lichtbogen vorliegt, was eine vergleichsweise kleinteilige Überwachung der Anlage ermöglicht.

Im Falle einer busartigen Verteilung ist insbesondere eine ähnliche Verwendung paralleler Strukturen aus Hauptstrompfad und Nebenstrompfad in den Bussegmenten oder davon abzweigenden Lastanbindungen möglich. Die Überwachung auf serielle Lichtbögen erstreckt sich dann bei der Platzierung der Kombinationen von Hauptstrompfad und Nebenstrompfad in Bussegmenten auf diese. Findet eine Platzierung im Bereich der Lastabgänge statt, werden diese Abgänge überwacht.

Insbesondere sind sämtliche Hauptstrompfade und Nebenstrompfad zueinander jeweils baugleich, sodass Gleichteile verwendet werden können. Alternativ hierzu sind diese auf den jeweiligen Anwendungsfall angepasst. Vorzugsweise ist jeweils einer der Hauptstrompfad und der zugeordnete Nebenstrompfad in einem gemeinsamen Gehäuse angeordnet, was eine Montage erleichtert.

Ein entsprechend ausgestalteter Schutzschalter wird zur Absicherung einer Anlage gegen einen seriellen Lichtbogen verwendet. Dabei wird insbesondere der Schutzschalter stets dann betrieben, wenn auch die Anlage betrieben wird.

Die im Zusammenhang mit dem Verfahren erläuterten Weiterbildungen und Vorteile sind sinngemäß auch auf den Schutzschalter / die Anlage / die Verwendung sowie untereinander zu übertragen und umgekehrt.

Nachfolgend werden Ausführungsbeispiele der Erfindung anhand einer Zeichnung näher erläutert. Darin zeigen:
- Fig. 1: schematisch eine Anlage mit einem Schutzschalter zur Absicherung gegen einen seriellen Lichtbogen,
- Fig. 2: ein Verfahren zum Betrieb des Schutzschalters, das ein Verfahren zum Erkennen eines seriellen Lichtbogens umfasst,
- Fig. 3: mehrere zeitliche Verläufe eines elektrischen Stroms, und
- Fig. 4: schematisch eine alternative Ausführungsform der Anlage.

Einander entsprechende Teile sind in allen Figuren mit den gleichen Bezugszeichen versehen.

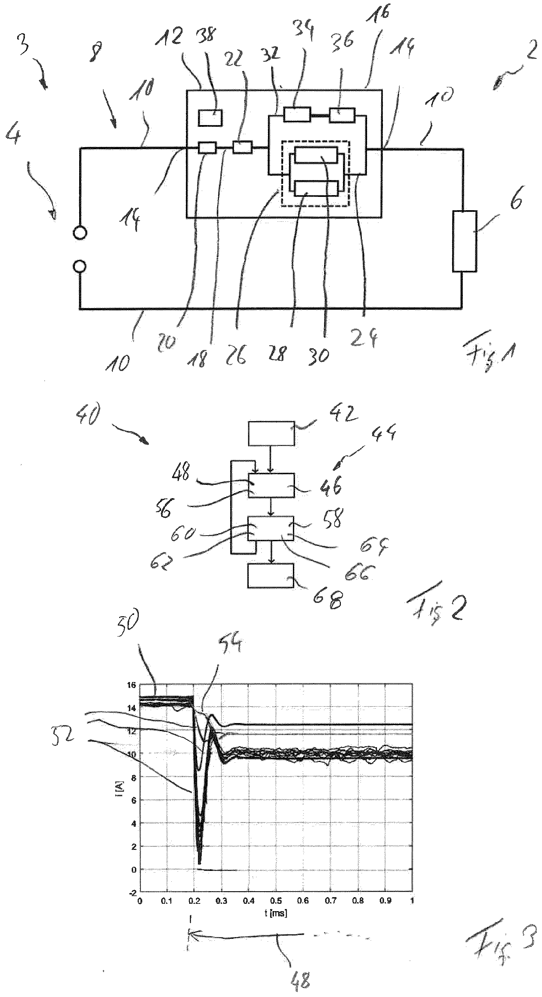

In Figur 1 ist schematisch vereinfacht ein Stromkreis 2 einer Anlage 3 dargestellt, die als Rechenzentrum ausgebildet ist. Der Stromkreis 2 weist eine Spannungsquelle 4 auf, mittels derer ein Gleichspannung in Höhe von 380 V bereitgestellt wird. Zudem umfasst der Stromkreis 2 / die Anlage 3 eine Last 6 in Form eines Großrechners. Die Spannungsquelle 4 und die Last 6 sind mittels einer Leitung 8 elektrisch verbunden, die drei Kabel 10 aufweist. Mittels eines der Kabel 10 sind der negative Pol der Spannungsquelle 4 und die Last 6 verbunden. Ein weiteres der Kabel 10 ist mit dem positiven Pol der Spannungsquelle 4 und einem Schutzschalter 12 verbunden. Das verbleibende Kabel 10 ist mit dem Schutzschalter 12 und der Last 6 verbunden. Somit bildet der Schutzschalter 12 einen Teil der Leitung 8, und in die Leitung 8 ist der Schutzschalter 12 eingebracht.

Der Schutzschalter 12 weist zwei Anschlüsse 14 auf, wobei an jeden der Anschlüsse 14 jeweils eines der Kabel der beiden zugeordneten Kabel 10 angeschlossen ist. Die Anschlüsse 14 sind in ein Gehäuse 16 des Schutzschalters 12 eingebracht, mittels dessen die verbleibenden Bestandteile des Schutzschalters 12 umgeben sind. Gegen einen der Anschlüsse 14 ist ein Messpfad 18 des Schutzschalters 12 geführt. Der Messpfad 18 weist einen Stromsensor 20 und einen Schalter 22 auf, die elektrisch in Reihe geschaltet sind. Der Schalter 22 ist beispielsweise als Schütz ausgestaltet oder weist in einer weiteren Alternative einen mechanischen Schalter, wie ein Relais, auf, zu dem parallel ein Halbleiterschalter geschaltet ist. Der Stromsensor 20 ist beispielsweise als Shunt ausgestaltet oder weist einen Hall-Sensor und/oder magnetoresisitven Sensor auf. In einer Alternative weist der Stromsensor 20 zwei unterschiedliche, nicht näher dargestellte Sensoreinheiten auf, wobei mittels eines davon der über den Messpfad18 geführte elektrische Strom über einen vergleichsweise großen Wertebereich erfasst werden kann. Insbesondere ist dieser Stromsensor als Gleichstromsensor ausgestaltet. Die andere Sensoreinheit ist als Wechselstromsensor ausgestaltet und weist eine vergleichsweise hohe Genauigkeit auf, zumindest wenn der Stromkreis 2 in einem Nennbereich betrieben wird.

Der Schutzschalter 12 umfasst ferner einen Hauptstrompfad 24, der elektrisch in Reihe zu dem Messpfad 18 geschaltet ist, und der mit dem verbleibenden Anschluss 14 elektrisch kontaktiert ist. Der Hauptstrompfad 14 weist eine Schalteinheit 26 auf, die einen mechanischen Schalter 28 in Form eines Schützes sowie einen hierzu parallelgeschalteten Halbleiterschalter 30 in Form eines MOSFETs umfasst und mittels dieser gebildet ist.

Elektrisch parallel zu dem Hauptstrompfad 24 ist ein Nebenstrompfad 32 geschaltet, der somit gegen einen der Anschlüsse 14 und gegen den Messpfad 18 geführt ist. Der Nebenstrompfad 32 weist eine Spannungssenke 34 auf, die elektrisch in Reihe mit einem Überstromschutz 36 in Form einer flinken Sicherung geschaltet ist. Die Spannungssenke 34 ist mittels einer Suppressordiode gebildet oder umfasst zumindest diese. Falls eine Montage des Schutzschalters 12 lediglich in einer einzigen Montageposition möglich ist und somit für eine einzige Stromrichtung gilt, ist die Suppressordiode als unipolare Suppressordiode ausgestaltet. Diese ist derart angeordnet, dass der gewünschte elektrische Stromfluss zwischen der Spannungsquelle 4 und der Last 6 entgegen der Sperrrichtung der Suppressordiode gerichtet ist. Falls der Schutzschalter 12 in zwei unterschiedlichen Montagepositionen montiert werden kann und/oder ein bidirektionaler Stromfluss auftritt/auftreten kann, ist die Suppressordiode beispielsweise bipolar ausgestaltet, oder die Spannungssenke 34 ist mittels zweier entgegengesetzt zueinander verschalteter unipolare Suppressordioden gebildet. Die Durchbruchsspannung der Suppressordiode(en) beträgt dabei jeweils13 V.

Ferner weist der Schutzschalter 12 eine Steuereinheit 38 auf, die mittels eines Mikrocontrollers oder eines anwendungsspezifischen Schaltkreises (ASIC) gebildet ist. Dabei wird mittels der Steuereinheit 38 zumindest teilweise ein Figur 2 dargestelltes Verfahren 40 zum Betrieb des Schutzschalters 12 durchgeführt. Mit anderen Worten ist der Schutzschalter 12 gemäß dem Verfahren 40 zum Betrieb des Schutzschalters 12 betrieben, und der Schutzschalter 12 ist ausgebildet, das Verfahren 40 durchzuführen.

Das Verfahren 40 zum Betrieb des Schutzschalters 12 wird in einem ersten Arbeitsschritt 42 gestartet. Der erste Arbeitsschritt 42 wird dabei durchgeführt, sobald die Anlage 2 in Betrieb genommen wird, oder zumindest sobald eine Bestromung der Last 6 erfolgt, sodass mittels der Last 6 eine bestimmte Tätigkeit durchgeführt wird. In dem ersten Arbeitsschritt 42 wird der Schalter 22 sowie die Schalteinheit 26 geschlossen, also in einen elektrisch leitfähigen Zustand überführt. Somit ist ein elektrischer Stromfluss über den Schutzschalter 12 ermöglicht, wobei die beiden Anschlüsse 14 niederohmig miteinander verbunden.

Im Anschluss hieran wird ein Verfahren 44 zum Erkennen eines seriellen Lichtbogens gestartet. Hierfür wird ein zweiter Arbeitsschritt 46 durchgeführt, in dem für einen ersten Zeitraum 48 die Schalteinheit 26 geöffnet wird, sodass der elektrische Stromfluss zwischen den Anschlüssen 14 von dem Hauptstrompfad 24 auf den Nebenstrompfad 32 kommutiert. Zum Öffnen der Schalteinheit 26 wird dabei zunächst der bis dahin elektrisch nichtleitende Halbleiterschalter 30 in den elektrisch leitenden Zustand versetzt, und anschließend der bis dahin geschlossene mechanische Schalter 28 in den elektrisch nichtleitenden Zustand versetzt. Im Anschluss hieran wird der Halbleiterschalter 30 erneut in den elektrisch nichtleitenden Zustand versetzt, was den Start des ersten Zeitraums 48 darstellt. Aufgrund einer derartigen Betätigung der Schalteinheit 26 ein entsteht bei deren Öffnen kein Lichtbogen.

Infolge des Kommutierens des elektrischen Stromflusses von dem Hauptstrompfad 24 auf den Nebenstrompfad 32 wirkt die Spannungssenke 34 auf den Stromkreis 2, und über den Schutzschalter 12 fällt eine konstante elektrische Spannung in Höhe von 13 V an, nämlich die Durchbruchsspannung der hier verwendeten Supressordiode. Daher weist ein mittels des Stromsensors 20 erfasster elektrische Strom 50, der von dem Messpfad 18 geführte wird, einen ersten Verlauf 52 auf der in Figur 3 dargestellt ist. Zu Beginn des ersten Zeitraums 52 sinkt der elektrische Strom 50 in einem Einschwingvorgang zunächst vergleichsweise stark ab, um danach erneut an zu steigen und nach einem erneuten geringeren Abfall sich auf einem Niveau zu stabilisieren, das geringer als das Niveau des elektrischen Stroms 50 vor Beginn des erster Zeitraums 48 war. In Figur 3 sind dabei mehrere entsprechende erste Verläufe 52 beispielhaft dargestellt, die sich bei unterschiedlichen Durchbruchsspannung der verwendeten Suppressordiode der Spannungssenke 34 ergeben. Der Stromsensor 30 wird hierbei getaktet betrieben, sodass der elektrische Strom 50 jeweils zu bestimmten, diskreten Zeitpunkten erfasst wird.

In Figur 3 ist zudem als Vergleich exemplarisch ein zweiter Verlauf 54 des elektrischen Stroms 50 dargestellt, der sich ergibt, wenn beispielsweise eine Stromaufnahme der Last 6 verändert wird, also insbesondere ein anderer Betriebspunkt der Last 6 gewählt wird. Bei diesem sinkt der elektrische Strom 50 über unterschiedliche Niveaus auf ein anderes Niveau ab, jedoch sind keine Überschwinger vorhanden. Mit anderen Worten ist der Einschwingprozess weniger stark ausgeprägt.

Anhand des erfassten elektrischen Stroms 50 wird ein Referenzsignal 56 erstellt, dessen zeitlicher Verlauf in Figur 3 dargestellt ist. Als Referenzsignal 56 wird dabei die skalierte Ableitung des in dem ersten Zeitraum 48 erfassten elektrischen Stroms 50 herangezogen. Somit weist, falls der elektrische Strom 50 den ersten Verlauf 52 aufweist, das Referenzsignal 56 ebenfalls zunächst ein vergleichsweise steiles Abfallen auf, um dann anzusteigen und wieder abzufallen. Als Skalar, also als Faktor, mittels dessen die jeweils erstellte Differenz multipliziert wird, wird das Verhältnis einer für einen seriellen Lichtbogen charakteristischen Spannung, wie 14 V, zu der Durchbruchspannung der verwendeten Suppressordiode herangezogen, also 13 V. Die Länge des ersten Zeitraums 48 beträgt 5 ms, und das Referenzsignal 56 ist beispielsweise genauso lang. Zumindest wird das Referenzsignal 56 anhand des in den ersten 0,5 ms des ersten Zeitraums 48 erfassten elektrischen Stroms 50 erstellt.

Sobald der erste Zeitraum 48 beendet ist, wird ein dritter Arbeitsschritt 58 gestartet. In diesem wird die Schalteinheit 26 geschlossen, wofür zunächst der Halbleiterschalter 30 in den elektrisch leitenden Zustand und anschließend der mechanische Schalter 28 in den elektrisch leitenden Zustand versetzt werden. Im Anschluss hieran wird erneut der Halbleiterschalter 30 in den elektrisch nichtleitenden Zustand versetzt. Somit sind die beiden Anschlüsse 14 erneut niederohmig miteinander verbunden, weswegen elektrisch Verluste reduziert sind. Auch ist keine elektrische Spannung zur Ansteuerung des mechanischen Schalters 28 erforderlich, weswegen auch hier elektrische Verluste verringert sind.

Mit Beginn des dritten Arbeitsschritts 58 wird ein zweiter Zeitraum 60 gestartet, dessen Länge 2 Sekunden beträgt. In dem zweiten Zeitraum 60 wird ebenfalls mittels des Stromsensors 20 der von dem Messpfad 18 geführte elektrische Strom 50 erfasst. Aus diesem wird ein Testsignal 62 erstellt, als das die Ableitung des erfassten elektrischen Stroms 50 herangezogen wird. Dabei wird das Testsignal 62, mit Ausnahme der Skalierung, in gleicher Art und Weise wie das Referenzsignal 56 erstellt. Hierbei wird mit jedem Messwert des erfassten elektrischen Stroms 50 ein neues Testsignal 62 begonnen, dessen Länge gleichen der Länge des Referenzsignals 56 ist. Folglich werden während des zweiten Zeitraums 60 mehrere Testsignale 62 erstellt, deren Startzeitpunkte jeweils zueinander verschoben sind.

Jedes der Testsignale 62 wird mit dem Referenzsignal 56 verglichen. Hierfür wird die Differenz zwischen jedem Wert des Referenzsignals 56 und dem Wert des jeweiligen Testsignal 62 erstellt. Mit anderen Worten wird den diskreten Zeitpunkten die Differenz zwischen dem Referenzsignal 56 und dem jeweiligen Testsignal 62 erstellt. Jede Differenz wird quadriert und die Summe der Quadrate addiert, sodass die L2-Norm erstellt wird, die als Abweichung 64 verwendet wird. Dabei wird für jedes Testsignal 62 die entsprechende Abweichung 64 erstellt.

Jede Abweichung 64, wird mit einem konstanten Grenzwert 66 verglichen. Falls keine der Abweichungen 64 kleiner als der Grenzwert 66 und der zweite Zeitraum 60 beendet ist, wird der zweite Arbeitsschritt 46 durchgeführt, sodass erneut der erste Zeitraum 48 gestartet wird. Mit anderen Worten wird, solange jede Abweichung 64 größer als der Grenzwert 66 ist, kontinuierlich das Verfahren 44 zum Erkennen des seriellen Lichtbogens durchgeführt. Folglich wird während des Betriebs der Anlage 3 mehrmals das Referenzsignal 56 erstellt, das auf den jeweiligen Betriebspunkt der Anlage 3 und somit auch des Stromkreises 2 angepasst ist. Mit anderen Worten ist es möglich, der sich die Referenzsignale 56 im Laufe der Zeit vergleichsweise stark voneinander unterscheiden, wobei dies aufgrund des Betriebs der Last 6 der Fall ist, ohne dass der serielle Lichtbogen vorhanden ist.

Hierbei ist es möglich, dass zwischen dem Beenden des dritten Arbeitsschritt 58 und dem zweiten Arbeitsschritt 46 ein weiterer Zeitraum vorhanden ist. Der erste Zeitraum 48 wird nämlich lediglich dann gestartet, wenn eine Veränderung des von dem Messpfads 18 geführten elektrischen Stroms 50 geringer als ein zweiter Grenzwert ist. Hierfür wird in dem zweiten Zeitraum 60 kontinuierlich die Varianz des geführten elektrischen Stroms 50 ermittelt und mit dem zweiten Grenzwert verglichen. Eine vergleichsweise hohe Varianz ergibt sich dabei bei einer gewünschten Änderung des Betriebspunkts der Last 6.

Falls jedoch eine der Abweichungen 64 kleiner als der Grenzwert 66 ist, ist der serielle Lichtbogen erkannt. Falls nämlich eine der Abweichungen 64 geringer als der Grenzwert 66 ist, verhält sich der elektrische Strom 50 in dem entsprechenden zweiten Zeitraum 60 zumindest kurzzeitig, als ob eine (zusätzliche) Spannungssenke vorhanden ist. Dabei verhält sich ein serieller Lichtbogen zu Beginn wie eine Spannungssenke.

Bei einer alternativen Ausgestaltung wird währen des zweiten Zeitraums 60 lediglich dann das Testsignal 62 erstellt, wenn eine bestimmte Bedingung erfüllt ist. Mit anderen Worten wird während des zweiten Zeitraums 60 zunächst überprüft, ob die Bedingung erfüllt ist. Wenn dies der Fall ist, wird das Referenzsignal 60 erstellt, wobei der Startpunkt des Referenzsignals 60 insbesondere der Zeitpunkt ist, an dem die Bedingung erfüllt wurde, oder eine bestimmte Zeitspanne vorher. Die Bedingung ist dabei insbesondere erfüllt, wenn der elektrische Strom in einem bestimmten Zeitraum um mehr als eine Schwelle absinkt und/oder wenn die Änderung des elektrischen Stroms, insbesondere der Betrag dessen zeitlicher Ableitung, größer als eine entsprechende Schwelle ist.

Falls der serielle Lichtbogen erkannt wurde, wird das Verfahren 44 zum Erkennen des seriellen Lichtbogens beendet, und es wird ein vierter Arbeitsschritt durchgeführt. In diesem wird der Schalter 22 geöffnet, sodass ein Stromfluss zwischen den Anschlüssen 14 des Schutzschalters 12 unterbunden wird, weswegen auch die Bestromung der Last 6 beendet wird. Aufgrund des Öffnens des Schalters 22 erlischt der serielle Lichtbogen, sodass eine weitere Beschädigung der Leitung 8 oder sonstiger Bestandteile der Anlage 3 verhindert wird. Folglich wird der Schutzschalter zur Absicherung der Anlage 3 gegen einen seriellen Lichtbogen verwendet.

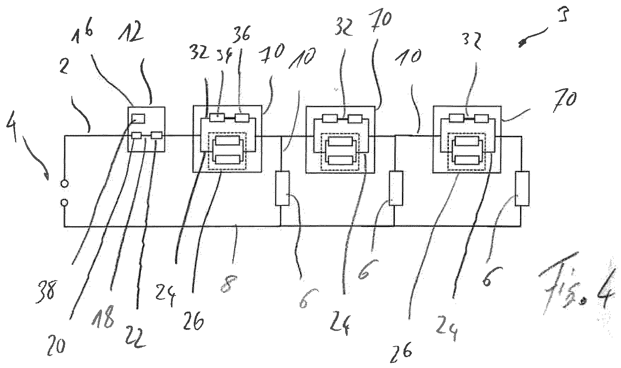

In Figur 4 ist eine Abwandlung der Anlage 3 und somit auch des Stromkreises 2 dargestellt, wobei die Spannungsquelle 4 nicht verändert ist. Mittels dieser wird auch weiterhin die Gleichspannung in Höhe von 380 V zur Verfügung gestellt. Es sind nunmehr insgesamt drei Lasten 6 vorhanden, die elektrisch parallel zueinander geschaltet sind, für die Leitung 8 angepasst ist und mehrere entsprechende Kabel 10 zur Anbindung der Lasten 6 aufweist. Die Lasten 6 können sich dabei hinsichtlich deren Ausprägung und/oder Bauart unterscheiden. Zudem ist es möglich, dass diese bei unterschiedlichen Betriebspunkten betrieben werden, sodass der in dem Stromkreis 2 fließende elektrische Strom vergleichsweise viele hochfrequente Anteile aufweist. Die Anlage 3 weist in dieser Variante insbesondere eine Bustopologie auf.

Der Schutzschalter 12 ist ebenfalls verändert, wobei bei einer nicht näher dargestellten Variante die vorherigen Ausführungsform verwendet wird. In diesem Fall befindet sich der Schutzschalter 12 zwischen einem der Pole der Spannungsquelle 4 und sämtlichen damit bestromten Lasten 6. Bei der in Figur 4 gezeigten Abwandlung des Schutzschalters 12 weist dieser insgesamt drei Hauptstrompfade 24 auf, die jeweils in einem separaten Gehäuse 70 angeordnet sind. Zu jedem der Hauptstrompfade 24 ist jeweils ein entsprechend zugeordneter Nebenstrompfad 32 parallel geschaltet. Die separaten Gehäuse 70 sowie die Hauptstrompfade 24 und Nebenstrompfade 32 mit deren jeweiligen Baueinheiten sind zueinander identisch, und jeder Hauptstrompfad 24 mit der Schalteinheit 26 entspricht dem Hauptstrompfad 24 der vorhergehenden Ausgestaltungsform. Auch jeder Nebenstrompfad 32 mit der jeweiligen Spannungssenke 34 und dem Überstromschutz 36 entsprechend jeweils der vorhergehenden Variante.

Die separaten Gehäuse 70 und somit auch die Hauptstrompfade 24 und daher auch die Nebenstrompfad 32 sind zueinander beabstandet. Dabei befinden sich zwischen jeweils benachbarten separaten Gehäuse 70 jeweils eine Abzweigung zu einer der Lasten 6, sodass über die einzelnen separaten Gehäuse 70 jeweils unterschiedlich hohe elektrische Ströme geführt werden. Bei einer nicht näher dargestellten Variante ist jedes separate Gehäuse 70 in den jeweiligen Zweig eingebracht, der zu der jeweiligen Last 6 geführt wird, sodass über jedes separate Gehäuse 70 lediglich der elektrische Strom geführt wird, der für die Bestromung der jeweiligen Last 6 verwendet wird. Bei der hier dargestellten Variante hingegen nimmt die Höhe des jeweils geführten elektrischen Stroms mit zunehmendem Abstand zu der Spannungsquelle 4 ab. Zusammenfassend weist somit der Schutzschalter 12 mehrere Hauptstrompfade 24 auf, zu den jeweils der entsprechende Nebenstrompfad 32 parallel geschaltet ist.

Der Messpfad 18 ist auch weiterhin in dem Gehäuse 16 angeordnet, in dem jedoch nunmehr kein Hauptstrompfads 24 und auch kein Nebenstrompfad 32 mehr vorhanden ist. Jedoch ist auch weiterhin der Stromsensor 20 sowie der Schalter 22 als auch die Steuereinheit 38 dort angeordnet, die signaltechnisch mit jeder der Schalteinheiten 26 verbunden ist.

Der Schutzschalter 12 wird weiterhin entsprechend des in Figur 2 dargestellten Verfahrens 40 betrieben, wobei ein entsprechend angepasstes Verfahren 44 zum Erkennen des seriellen Lichtbogens verwendet wird. Hierbei ist jedem separaten Gehäuse 70 ein entsprechender erster Zeitraum 48 zugeordnet, die sukzessive hintereinander gestartet werden. Somit wird für jeden Unterabschnitt der Leitung 8, der das entsprechende separate Gehäuse 70 aufweist, das Vorliegen eines seriellen Lichtbogens simuliert, wofür ein entsprechendes Referenzsignal 56 erstellt wird. Der elektrische Strom 50 wird dabei in jedem der ersten Zeiträume 48 mittels des gleichen Stromsensors 20 gemessen.

Nach den drei ersten Zeiträumen 48 wird wiederum stets der zweite Zeitraum 60 gestartet. Falls während eines der zweiten Zeiträume 60 ein Testsignal 62 vorliegt, bei dem die Abweichung 64 zu einem der drei Referenzsignale 56 geringer als der Grenzwert 66 ist, liegt der serielle Lichtbogen vor. Dabei ist anhand des korrespondierenden Referenzsignals 56 auch bestimmbar, wo in welchem Unterabschnitt der Leitung 8 sich der serielle Lichtbogen ausgebildet hat.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung, wie er in den beigefügten Ansprüchen definiert ist, zu verlassen. Insbesondere sind ferner alle im Zusammenhang mit den einzelnen Ausführungsbeispielen beschriebene Einzelmerkmale auch auf andere Weise miteinander kombinierbar, ohne den Gegenstand der Erfindung, wie er in den beigefügten Ansprüchen definiert ist, zu verlassen.

### Bezugszeichenliste

- 2: Stromkreis
- 3: Anlage
- 4: Spannungsquelle
- 6: Last
- 8: Leitung
- 10: Kabel
- 12: Schutzschalter
- 14: Anschluss
- 16: Gehäuse
- 18: Messpfad
- 20: Stromsensor
- 22: Schalter
- 24: Hauptstrompfad
- 26: Schalteinheit
- 28: mechanischer Schalter
- 30: Halbleiterschalter
- 32: Nebenstrompfad
- 34: Spannungssenke
- 36: Überstromschutz
- 38: Steuereinheit
- 40: Verfahren zum Betrieb eines Schutzschalters
- 42: erster Arbeitsschritt
- 44: Verfahren zum Erkennen eines seriellen Lichtbogens
- 46: zweiter Arbeitsschritt
- 48: erster Zeitraum
- 50: elektrischer Strom
- 52: erster Verlauf
- 54: zweiter Verlauf
- 56: Referenzsignal
- 58: dritter Arbeitsschritt
- 60: zweiter Zeitraum
- 62: Testsignal
- 64: Abweichung
- 66: Grenzwert
- 68: vierter Arbeitsschritt
- 70: separates Gehäuse

## Patentansprüche

1. Verfahren (44) zum Erkennen eines seriellen Lichtbogens in einem Stromkreis (2), der einen Hauptstrompfad (24) mit einer Schalteinheit (26), einen hierzu parallel geschalteten Nebenstrompfad (32) mit einer Spannungssenke (34) und einen Messpfad (18) mit einem Stromsensor (20) aufweist, welcher elektrisch in Reihe zu dem Hauptstrompfad (24) und dem Nebenstrompfad (32) geschaltet ist, bei welchem
- für einen ersten Zeitraum (48) die Schalteinheit (26) geöffnet und mittels des Stromsensors (20) der von dem Messpfad (18) geführte elektrische Strom (50) erfasst und hieraus ein Referenzsignal (56) erstellt wird,
- für einen zweiten Zeitraum (60), in dem die Schalteinheit (26) geschlossen ist, der von dem Messpfad (18) geführte elektrische Strom (50) erfasst und hieraus ein Testsignal (62) erstellt wird, und
- das Testsignal (62) mit dem Referenzsignal (56) vergleichen wird, wobei der serielle Lichtbogen erkannt wird, wenn eine Abweichung (64) zwischen dem Testsignal (62) und dem Referenzsignal (56) kleiner als ein Grenzwert (66) ist.

2. Verfahren (44) nach Anspruch 1,
**dadurch gekennzeichnet,**
**dass** nach dem zweiten Zeitraum (60) erneut der erste Zeitraum (48) gestartet wird.

3. Verfahren (44) nach Anspruch 1 oder 2,
**dadurch gekennzeichnet,**
**dass** eine Länge des zweiten Zeitraums (60) zwischen 0,5 Sekunden und 5 Sekunden gewählt wird.

4. Verfahren (44) nach einem der Ansprüche 1 bis 3,
**dadurch gekennzeichnet,**
**dass** eine Länge des ersten Zeitraums (48) zwischen 0,1 ms und 10 ms gewählt wird.

5. Verfahren (44) nach einem der Ansprüche 1 bis 4,
**dadurch gekennzeichnet,**
**dass** der erste Zeitraum (48) lediglich dann gestartet wird, wenn eine Veränderung des von dem Messpfad (18) geführten elektrischen Stroms (50) geringer als ein zweiter Grenzwert ist.

6. Verfahren (44) nach einem der Ansprüche 1 bis 5,
**dadurch gekennzeichnet,**
**dass** als Referenzsignal (56) die skalierte Ableitung des erfassten elektrischen Stroms (50) herangezogen wird.

7. Verfahren (44) nach einem der Ansprüche 1 bis 6,
**dadurch gekennzeichnet,**
**dass** zu diskreten Zeitpunkten die Differenz zwischen dem Referenzsignal (56) und dem Testsignal (62) erstellt wird, wobei die Abweichung (64) anhand der Differenzen erstellt wird.

8. Verfahren (44) nach einem der Ansprüche 1 bis 7,
**dadurch gekennzeichnet,**
**dass** zum Öffnen der Schalteinheit (26) zunächst ein mechanischer Schalter (28) der Schalteinheit (26) und anschließend ein hierzu parallel geschalteter Halbleiterschalter (30) der Schalteinheit (26) in den elektrisch nichtleitenden Zustand versetzt wird.

9. Schutzschalter (12) zur Absicherung gegen einen seriellen Lichtbogen, welcher einen Hauptstrompfad (24) mit einer Schalteinheit (26), einen hierzu parallel geschalteten Nebenstrompfad (32) mit einer Spannungssenke (34) und einen Messpfad (18) mit einem Stromsensor (20) und einem Schalter (22) aufweist, welcher elektrisch in Reihe zu dem Hauptstrompfad (24) und dem Nebenstrompfad (32) geschaltet ist, und welcher ausgebildet ist, ein Verfahren (44) nach einem der Ansprüche 1 bis 8 durchzuführen, und den Schalter (22) zu betätigen, wenn der serielle Lichtbogen erkannt wurde.

10. Schutzschalter (12) nach Anspruch 9,
**dadurch gekennzeichnet,**
**dass** die Spannungssenke (34) eine Suppressordiode umfasst.

11. Schutzschalter (12) nach Anspruch 9 oder 10,
**dadurch gekennzeichnet,**
**dass** der Nebenstrompfad (32) einen Überstromschutz (36) umfasst.

12. Anlage (3) aufweisend eine Spannungsquelle (4), eine Leitung (8) und mehrere Lasten (6) die mittels der ee Leitung (8) elektrisch verbunden sind, wobei in die Leitung (8) ein Schutzschalter (12) nach einem der Ansprüche 9 bis 11 eingebracht ist.

13. Anlage (3) nach Anspruch 12,
**dadurch gekennzeichnet,**
**dass** der Schutzschalter (12) mehrere Hauptstrompfade (24) aufweist, zu denen jeweils ein entsprechender Nebenstrompfad (32) parallel geschaltet ist, wobei die Hauptstrompfade (24) zueinander beabstandet sind.

14. Verwendung eines Schutzschalters (12) nach einem der Ansprüche 9 bis 11 zur Absicherung einer Anlage (3) nach Anspruch 12 oder 13 gegen einen seriellen Lichtbogen.

## Claims

1. Method (44) for identifying a serial arc in a circuit (2) which has a main current path (24) with a switching unit (26), an auxiliary current path (32) connected in parallel therewith and with a voltage sink (34), and a measurement path (18) with a current sensor (20), which is electrically connected in series with the main current path (24) and the auxiliary current path (32), in which method
- the switching unit (26) is opened for a first period of time (48) and the electric current (50) conducted by the measurement path (18) is detected by means of the current sensor (20), and a reference signal (56) is generated therefrom,
- for a second period of time (60), during which the switching unit (26) is closed, the electric current (50) conducted by the measurement path (18) is detected and a test signal (62) is generated therefrom, and
- the test signal (62) is compared with the reference signal (56), wherein the serial arc is identified if a deviation (64) between the test signal (62) and the reference signal (56) is less than a limit value (66).

2. Method (44) according to Claim 1,
**characterized**
**in that** the first period of time (48) is restarted after the second period of time (60).

3. Method (44) according to Claim 1 or 2,
**characterized**
**in that** the second period of time (60) is selected to be between 0.5 seconds and 5 seconds in length.

4. Method (44) according to one of Claims 1 to 3, **characterized**
**in that** the first period of time (48) is selected to be between 0.1 ms and 10 ms in length.

5. Method (44) according to one of Claims 1 to 4, **characterized**
**in that** the first period of time (48) is started only when a change in the electric current (50) conducted by the measurement path (18) is less than a second limit value.

6. Method (44) according to one of Claims 1 to 5, **characterized**
**in that** the reference signal (56) used is the scaled derivative of the detected electric current (50).

7. Method (44) according to one of Claims 1 to 6, **characterized**
**in that** the difference between the reference signal (56) and the test signal (62) is calculated at discrete times, wherein the deviation (64) is calculated on the basis of the differences.

8. Method (44) according to one of Claims 1 to 7, **characterized**
**in that**, in order to open the switching unit (26), initially a mechanical switch (28) of the switching unit (26) and subsequently a semiconductor switch (30) of the switching unit (26), connected in parallel therewith, are put in the electrically non-conductive state.

9. Circuit breaker (12) for protecting against a serial arc, which has a main current path (24) with a switching unit (26), an auxiliary current path (32) connected in parallel therewith and with a voltage sink (34), and a measurement path (18) with a current sensor (20) and a switch (22), which is electrically connected in series with the main current path (24) and the auxiliary current path (32), said circuit breaker being designed to carry out a method (44) according to one of Claims 1 to 8 and to actuate the switch (22) if the serial arc has been identified.

10. Circuit breaker (12) according to Claim 9,
**characterized**
**in that** the voltage sink (34) comprises a suppressor diode.

11. Circuit breaker (12) according to Claim 9 or 10, **characterized**
**in that** the auxiliary current path (32) comprises overcurrent protection (36).

12. Installation (3) having a voltage source (4), a line (8), and a plurality of loads (6) which are electrically connected by means of the line (8), wherein a circuit breaker (12) according to one of Claims 9 to 11 is incorporated into the line (8).

13. Installation (3) according to Claim 12,
**characterized**
**in that** the circuit breaker (12) has a plurality of main current paths (24), each of which has a corresponding auxiliary current path (32) connected in parallel therewith, wherein the main current paths (24) are spaced apart from one another.

14. Use of a circuit breaker (12) according to one of Claims 9 to 11 for protecting an installation (3) according to Claim 12 or 13 against a serial arc.

## Revendications

1. Procédé (44) d'identification d'un arc électrique série dans un circuit (2) qui présente un trajet de courant principal (24) comportant une unité de commutation (26), un trajet de courant secondaire (32) connecté en parallèle à celui-ci et comportant un puits de tension (34) et un trajet de mesure (18) comportant un capteur de courant (20), lequel est connecté électriquement en série au trajet de courant principal (24) et au trajet de courant secondaire (32), dans lequel
- pendant une première période de temps (48), l'unité de commutation (26) est ouverte et, au moyen du capteur de courant (20), le courant électrique (50) conduit par le trajet de mesure (18) est détecté et un signal de référence (56) est créé à partir de celui-ci,
- pendant une deuxième période de temps (60), au cours de laquelle l'unité de commutation (26) est fermée, le courant électrique (50) conduit par le trajet de mesure (18) est détecté et un signal de test (62) est créé à partir de celui-ci, et
- le signal de test (62) est comparé au signal de référence (56), dans lequel l'arc électrique série est identifié si un écart (64) entre le signal de test (62) et le signal de référence (56) est inférieur à une valeur limite (66).

2. Procédé (44) selon la revendication 1,
**caractérisé en ce**
**qu'**après la deuxième période de temps (60), la première période de temps (48) est recommencée.

3. Procédé (44) selon la revendication 1 ou 2, **caractérisé en ce**
**qu'**une longueur de la deuxième période de temps (60) est choisie entre 0,5 seconde et 5 secondes.

4. Procédé (44) selon l'une des revendications 1 à 3, **caractérisé en ce**
**qu'**une longueur de la première période de temps (48) est choisie entre 0,1 ms et 10 ms.

5. Procédé (44) selon l'une des revendications 1 à 4, **caractérisé en ce**
**que** la première période de temps (48) ne commence que si une modification du courant électrique (50) conduit par le trajet de mesure (18) est inférieure à une deuxième valeur limite.

6. Procédé (44) selon l'une des revendications 1 à 5, **caractérisé en ce**
**que** la dérivée mise à l'échelle du courant électrique (50) détecté est utilisée comme signal de référence (56).

7. Procédé (44) selon l'une des revendications 1 à 6, **caractérisé en ce**
**que** la différence entre le signal de référence (56) et le signal de test (62) est créée à des instants discrets, l'écart (64) étant créé à partir des différences.

8. Procédé (44) selon l'une des revendications 1 à 7, **caractérisé en ce**
**que** pour ouvrir l'unité de commutation (26), un commutateur mécanique (28) de l'unité de commutation (26) puis un commutateur à semi-conducteur (30), connecté en parallèle à celui-ci, de l'unité de commutation (26) sont mis à l'état électriquement non conducteur.

9. Disjoncteur (12) de protection contre un arc électrique série, lequel présente un trajet de courant principal (24) comportant une unité de commutation (26), un trajet de courant secondaire (32) connecté en parallèle à celui-ci et comportant un puits de tension (34) et un trajet de mesure (18) comportant un capteur de courant (20) et un commutateur (22), lequel est connecté électriquement en série au trajet de courant principal (24) et au trajet de courant secondaire (32), et lequel est conçu pour mettre en œuvre un procédé (44) selon l'une des revendications 1 à 8, et pour actionner le commutateur (22) lorsque l'arc électrique série a été identifié.

10. Disjoncteur (12) selon la revendication 9, **caractérisé en ce**
**que** le puits de tension (34) comporte une diode de suppression.

11. Disjoncteur (12) selon la revendication 9 ou 10, **caractérisé en ce**
**que** le trajet de courant secondaire (32) comporte une protection contre les surintensités (36).

12. Système (3) comportant une source de tension (4), une ligne (8) et plusieurs charges (6) qui sont connectées électriquement au moyen de la ligne (8), dans lequel un disjoncteur (12) selon l'une des revendications 9 à 11 est inséré dans la ligne (8).

13. Système (3) selon la revendication 12,
**caractérisé en ce**
**que** le disjoncteur (12) présente plusieurs trajets de courant principaux (24) auxquels est connecté en parallèle respectivement un trajet de courant secondaire (32) correspondant, les trajets de courant principaux (24) étant espacées les uns des autres.

14. Utilisation d'un disjoncteur (12) selon l'une des revendications 9 à 11 pour la protection d'un système (3) selon la revendication 12 ou 13 contre un arc électrique série.
